# EUROPÄISCHE PATENTSCHRIFT

(11) **EP 0 265 767 B1**
(45) Veröffentlichungstag und Bekanntmachung des Hinweises auf die Patenterteilung: **26.10.1994**
(21) Anmeldenummer: 87114942.3
(22) Anmeldetag: 13.10.1987
(51) Int. Cl.: G01R 1/073

(54) **Nadelkarte**
Probe card
Carte à aiguilles

(30) Priorität: 14.10.1986 DE 3634959
(43) Veröffentlichungstag der Anmeldung: 04.05.1988
(73) Patentinhaber: Feinmetall Gesellschaft mit beschränkter Haftung, D-71072 Herrenberg (DE)
(72) Erfinder: Giringer, Klaus, D-7033 Herrenberg (DE)
(74) Vertreter: Gleiss, Alf-Olav, Dr.jur. Dipl.-Ing.

(56) Entgegenhaltungen:
- EP-A- 0 068 270
- DE-A- 3 337 915
- DE-A- 3 343 274
- FR-A- 2 072 196
- FR-A- 2 275 781

## Beschreibung

### Nadelkarte

Die Erfindung betrifft eine Nadelkarte gemäß dem Oberbegriff des Anspruches 1.

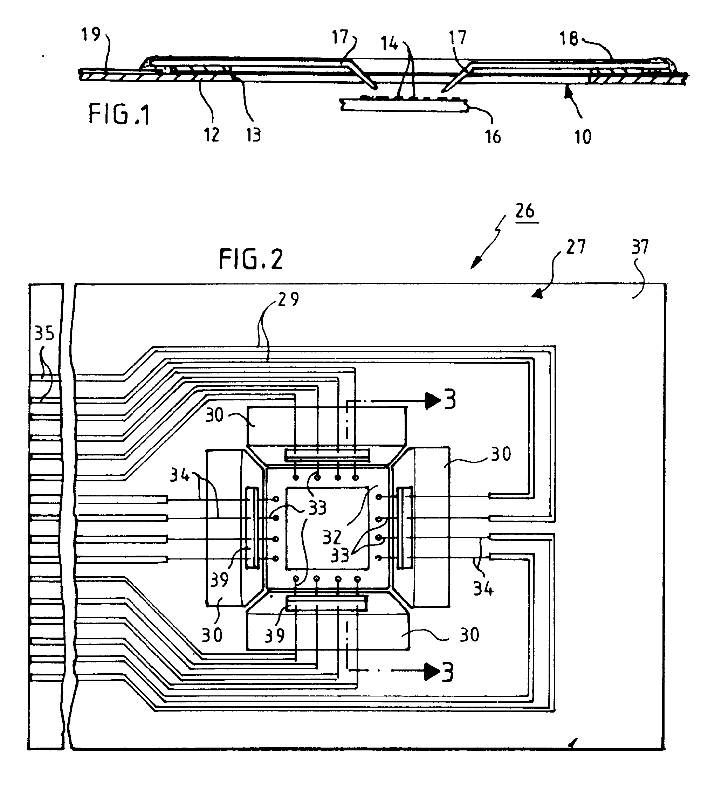

Solche Nadelkarten (auch Prüfkarten oder Leiterkarten genannt) sind bekannt (KULLEN "Waferprüfung - ein mikrotechnisches Problem", Jahrbuch der Deutschen Gesellschaft für Chronometrie, Nr. 36/1985, S. 85-92b). Sie werden an Prüfköpfen oder Prüfadaptern von Waferprobern oder sonstigen Prüfvorrichtungen zum Prüfen von Chips auf Wafers angeordnet und weisen dem elektrischen Anschluß der Nadeln dienende Leiter, insbesondere Leiterbahnen auf. In Fig. 1 ist ein Teilschnitt durch eine bekannte Nadelkarte 10 dargestellt. Sie weist eine Leiterplatte 12 mit einer meist runden oder ovalen Öffnung 13 in der Mitte auf, durch die die dem Kontaktieren der Pads 14 jeweils eines Chips eines viele solcher Chips aufweisenden Wafers 16 dienenden Nadeln 17, von denen nur zwei dargestellt sind, hindurchragen. Die Schäfte der Nadeln 17 sind in einem auf die Nadelkarte 10 aufgesetzten Kunststoffring 18 parallel zur Ebene der Leiterplatte 12 gehalten und mit den zugeordneten Leiterbahnen 19 auf der Leiterplatte 12 bspw. durch Lötstellen elektrisch verbunden. Die Nadeln 17 dieser Nadelkarte 10 können jeweils nur die Pads eines einzigen Chips gleichzeitig kontaktieren und sind elektrisch an eine für die Prüfung jeweils eines einzigen Chips ausgebildete Testvorrichtung angeschlossen. Zu diesem Zweck enden die Leiterbahnen 19 in der Regel an einer nicht dargestellten Steckerleiste, die den Anschluß der Nadel 12 an eine Testvorrichtung der betreffenden Prüfvorrichtung, die die elektrische Prüfung durchführt, herstellt. Die Nadeln 17 sind, um alle Pads 14 des Chips gleichzeitig zu kontaktieren, an ihren vorderen Enden um etwa 45° bis 60° nach unten abgebogen. Der Kontaktiervorgang läuft so ab, daß die Nadelkarte auf den Wafer abgesenkt wird, bis die Nadeln 17 sicheren Kontakt mit den Pads 14 des jeweils zu prüfenden Chips haben. Die Nadeln federn dabei etwas eleastisch aus und ihre Nadelspitzen führen dabei Gleitbewegungen auf den Pads 14 aus, die die Gefahr von Beschädigungen der Pads in sich bergen. Bei den modernen hochintegrierten, durch die Chips gebildeten Schaltkreisen ist die Anzahl der Pads pro Chip oft sehr groß. Die Nadelkarte 10 kontaktiert jeweils die Pads eines Chips gleichzeitig. Auf einem Wafer sind sehr viele Chips von normalerweise quadratischer oder rechteckförmiger Gestalt in geringen Abständen nebeneinander angeordnet und die Pads befinden sich nahe den Rändern des Chips an allen vier Seiten des Chips. Es sind schon Nadelkarten mit 256 Nadeln hergestellt worden, so daß entsprechend mit solchen Nadelkarten nur Chips mit maximal 256 Pads prüfbar waren. Die Anfertigung derartiger Nadelkarten ist um so komplizierter und teurer, je größer die Anzahl der Nadeln ist, da die Nadelabstände sehr klein sind und die Nadelspitzen mit höchster Präzizion entsprechend der Anordnung der Pads der Chips ausgerichtet werden müssen, was bei solchen Nadeln sehr schwierig ist. Infolge des geringen Durchmessers des Nadelschaftes können diese Nadeln bei unsachgemäßer Handhabung auch leicht verbogen werden, insbesondere bei Nadelkarten mit sehr vielen Nadeln. Aus Platzgründen sind bei solchen Nadelkarten mit sehr vielen Nadeln die frei über die Leiterplatte überstehenden Längen der Nadeln besonders groß und sie sind dann besonders empfindlich.

Aus der Entgegenhaltung FR-A-2 275 781 geht eine nicht kartenförmig ausgebildete Kontaktiereinrichtung hervor, die Nadeln aufweist, welche sich in axialer Richtung gerade erstrecken und mit ihren Enden gegen starre Gegenkontakte treten. Die Gegenkontakte werden von in Kunstharz eingebetteten Drahtenden von Kabeln gebildet, wobei die Kabel zu Kontakten einer Leiterplatte führen.

Aus der Literaturstelle FR-A-2 072 196 ist eine ebenfalls nicht kartenförmige Kontaktiereinrichtung bekannt, die Kontaktdrähte aufweist, welche in bogenförmig verlaufenden Röhrchen mit radialem Spiel einliegen. Durch dieses Spiel liegt eine unpräzise Führung vor; überdies besteht keine elastische Federung der Drähte. Aufgrund der Röhrchen sind nur relativ große Drahtabstände realisierbar.

Der Erfindung liegt die Aufgabe zugrunde, eine Nadelkarte zu schaffen, die bei optimaler Kontaktierung eine besonders große Nadelanzahl mit äußerst geringen Abständen der freien Nadelspitzen voneinander zuläßt.

Diese Aufgabe wird erfindungsgemäß durch eine Nadelkarte gemäß Anspruch 1 gelöst.

Diese Nadelkarte ermöglicht auf kostengünstige, baulich einfache Weise sehr hohe Anzahlen von Nadeln, insbesondere auch Nadelanzahlen, die ohne weiteres auch wesentlich größer als 256 sein können, beispielsweise doppelt so groß oder auch noch größer sein können. Dabei gelingt dies bei relativ einfacher Bauart der Nadelkarte. Auch lassen sich die Nadeln kostengünstig herstellen. Die Nadeln können aus Draht, vorzugsweise aus Runddraht, hergestellt sein und sehr geringe Durchmesser von vorzugsweise weniger als 0,1 mm aufweisen. Der sie bildende Draht kann vorzugsweise aus Stahl, Kupferberyllium, Wolfram, Edelmetall, Edelmetallegierungen oder sonstigen federelastischen Metallen bestehen, beispielsweise oft zweckmäßig auch aus verschiedenen metallischen Werkstoffen im Verbund bestehen. Damit die Nadelspitze axial federn kann, weist jede Nadel mindestens eine Krümmung auf, die ihr federndes Biegen beim Kontaktieren von Pads ermöglicht.

Diese Nadel übt, zumindest dann, wenn sie im Betrieb einen Wafer kontaktiert und durch ihn in der zugeordneten Bohrung der Führungsplatte axial verschoben wird, auf diese Führungsplatte sowohl in ihrer axialen Richtung Reibungskräfte als auch durch ihre Krümmung Querkräfte aus. Um die Querkräfte besonders klein zu halten oder ganz zu vermeiden, kann gemäß einer Weiterbildung der Erfindung vorgesehen sein, daß im Abstand von der Führungsplatte eine Stützplatte angeordnet ist, die ebenfalls von den Nadeln mit axialem Gleitlagerspiel durchdrungene Bohrungen aufweist und die die Querkräfte ganz oder weitgehend aufnehmen kann. Hierdurch ist die Führungsplatte weniger belastet und kann besonders dünn ausgebildet sein, was es erleichtert und kostengünstiger möglich macht, die Bohrungen in ihr für die Nadeln mit höchster Präzision kostengünstig herzustellen, vorzugsweise zu bohren.

Da die Mittenabstände benachbarter Pads des einzelnen Chips stets sehr klein sind, bspw. 0,14 mm oder ggf. auch noch kleiner (oder in manchen Fällen auch größer) sein können, ist in jedem Fall höchste Präzision für die Stellung der Nadelspitzen erforderlich, was die Führungsplatte auf einfache Weise ermöglicht.

Auch läßt die Führungsplatte, welche die Nadeln in ihrem Bereich auch gegeneinander elektrisch isoliert, wesentlich besser und sicherer als bei der vorbekannten Nadelkarte nach Fig. 1 versehentlichen Kontakt benachbarter Nadeln miteinander vermeiden. Solcher Kontakt würde die Nadelkarte unbrauchbar machen. Es lassen sich durch die Erfindung also äußerst geringe Abstände der freien Nadelspitzen der Nadeln voneinander ohne Gefahr des Berührens dieser Nadeln miteinander erreichen.

Bevorzugt können die Längsachsen der die Nadeln führenden Löcher der Führungsplatte senkrecht zu der Ebene des jeweils zu prüfenden Wafers gerichtet sein, was auch Gleiten der Nadelspitzen auf den Pads der Chips und damit die Gefahr von Beschädigungen der Pads durch die Nadelspitzen einfach vermeiden läßt, indem der in der Führungsplatte geführte Endbereich der Nadel bis zur freien Nadelspitze dabei gerade ist, so daß es beim Kontaktieren von Pads nicht zu Gleiten der Nadelspitze auf den Pads kommen kann. Falls es jedoch erwünscht ist, daß die Nadelspitzen aus Gründen besonders guten elektrischen Kontakts etwas gleiten, können die Längsachsen der Nadelführungslöcher der Führungsplatte auch zur Ebene des jeweils zu prüfenden Wafers schräg geneigt sein, bspw. um 1° bis 25° und/oder die Nadeln zwischen ihren freien Nadelspitzen und der Führungsplatte mindestens eine Krümmung aufweisen. Die erfindungsgemäße Nadelkarte zeichnet sich durch hohe Betriebssicherheit aus und die Gefahr von Beschädigungen der Nadeln ist äußerst gering. Man kann deshalb in vielen Fällen zweckmäßig vorsehen, daß die Nadeln nichtlösbar gehalten sind. Man kann dann wegen der geringen oder praktisch vernachlässigbaren Beschädigungsgefahr in Kauf nehmen, daß im Falle der Beschädigung einer Nadel die Nadelkarte hierdurch unbrauchbar geworden ist und gegen eine neue Nadelkarte ausgetauscht werden muß.

Die Erfindung ermöglicht es jedoch gemäß einer Weiterbildung auch, die Auswechselbarkeit der Nadeln vorzusehen. Hierzu kann besonders zweckmäßig vorgesehen sein, daß die Nadeln in den sie aufnehmenden Löchern der Nadelkarte lösbar, vorzugsweise durch Reibung gehalten sind. Die einzelne Nadel kann so unter Überwindung der Reibungskraft herausgezogen und gegen eine neue Nadel ausgewechselt werden. Dabei kann zweckmäßig vorgesehen sein, daß das rückwärtige Ende der einzelnen Nadel an einem ein Widerlager für sie bildenden elektrischen Kontakt anliegt, der mit der betreffenden Leiterbahn der Leiterkarte elektrisch verbunden ist. Der elektrische Anschluß der einzelnen Nadel ergibt sich dann durch Einsetzen in die sie aufnehmenden Löcher von selbst, indem man sie bis zum Anliegen an den fest an der Nadelkarte angeordneten Kontakt andrückt. Im Betrieb wird durch das Kontaktieren der Pads der Chips der Anpreßdruck der rückwärtigen Enden der Nadel an die Kontakte noch erhöht und so sichere elektrische Verbindung der Nadeln mit zugeordneten Leitern der Leiterplatte auf einfache Weise gewährleistet. Die Leiter der Leiterplatte könen Leiterbahnen oder ggf. auch andere elektrische Leiter sein.

Die Führungsplatte bzw. Stützplatte oder Halteplatte können sehr dünn sein, so daß die Bohrungen in sie leicht einbringbar sind. Vorzugsweise können sie dünner als 2 mm sein, vorzugsweise ungefähr 0,5 bis 1,5 mm, besonders zweckmäßig ungefähr 1 mm dick sein.

Es ist bei solchen Nadelkarten erwünscht, daß eine mikroskopische Durchblickmöglichkeit besteht, bspw. zur Beobachtung der Spitzen der Nadeln, um das genaue Kontaktieren der Mitten der Pads der Chips kontrollieren zu können oder aus sonstigen Gründen, bspw. zum Justieren einer Düse zum Inken als defekt ermittelter Chips.

Zu diesem Zweck kann die Nadelkarte vorzugsweise innerhalb der Nadeln der Nadelanordnung für die mikroskopische Betrachtung der Nadelspitzen oder der Düse zum Inken oder dergl. eine entsprechende Öffnung oder Öffnungen aufweisen oder durchsichtiges Material aufweisen,so daß hierdurch mindestens ein Durchblickfenster der Nadelkarte vorhanden ist. In manchen Fällen kann jedoch für einen solchen Zweck bzw. solche Zwecke auch außerhalb der Nadelanordnung mindestens ein Durchblickfenster in der Nadelkarte vorgesehen sein, bspw. mindestens ein Durchbruch oder mindestens einen auf sonstige Weise durchsichtigen Bereich.

Von den Stellen aus, an denen die rückwärtigen Nadelbereiche gegen axiales Verschieben gehalten sind, können sie zweckmäßig über elektrische Verbindungsdrähte mit den insbesondere als Leiterbahnen ausgebildeten Leitern der Leiterplatte verbunden sein. Es kann sich hier um gesonderte elektrische Verbindungsdrähte handeln, die an die Nadeln angelötet oder angeschweißt oder sonstwie mit den Nadeln verbunden oder auch mit den Nadeln einstückige Verlängerungen der Nadeln sein können. Oder diese elektrischen Verbindungsleitungen sind an die erwähnten, als Widerlager dienenden Kontakte angeschlossen, an die die rückwärtigen Enden der Nadeln im Falle ihrer Auswechselbarkeit angedrückt sind oder angedrückt werden können.

In den Fig. 2 bis 10 sind Ausführungsbeispiele der Erfindung dargestellt. Es zeigen:
- Fig. 2: eine gebrochene Draufsicht auf eine Nadelkarte gemäß einem Ausführungsbeispiel der Erfindung,
- Fig. 3: einen Teilschnitt durch die Nadelkarte nach Fig. 2 gesehen entlang der Schnittlinie 3-3 der Fig. 2 in vergrößerter Darstellung,
- Fig. 4-7 und 9: Teilschnitt durch Nadelkarten gemäß weitern Ausführungsbeispielen der Erfindung,
- Fig. 8: eine Vorderansicht eines Ausschnittes aus Fig. 7 gesehen in Richtung des Pfeiles A,
- Fig.10: einen Schnitt durch eine Nadelführung gemäß einem weiteren Ausführungsbeispiel der Erfindung.

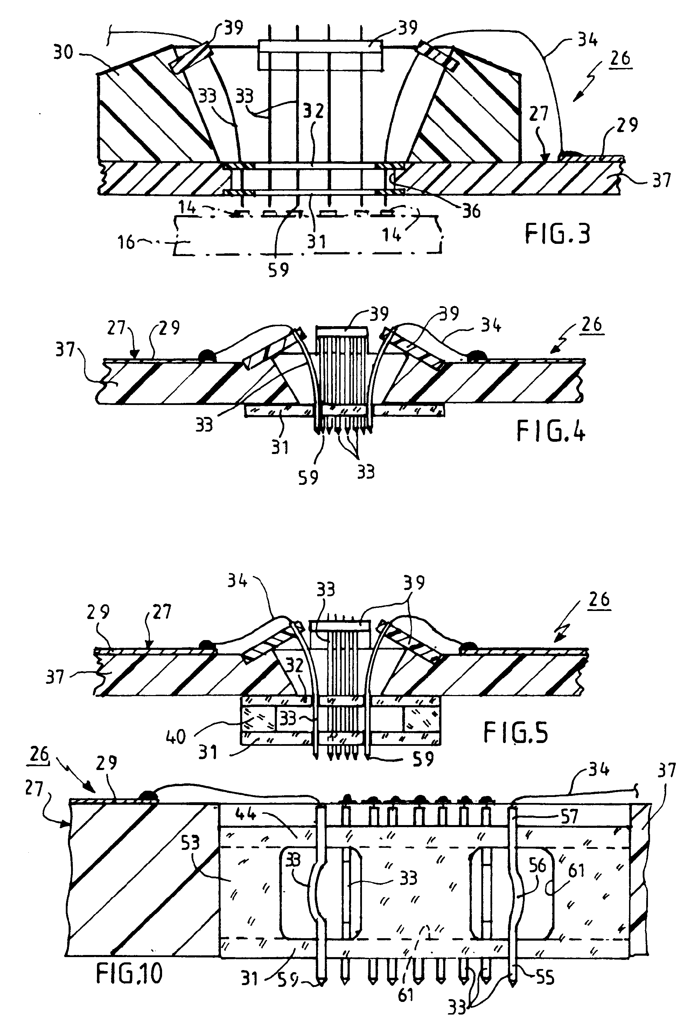

Die in den Figuren 2 und 3 jeweils ausschnittsweise dargestellte Nadelkarte 26 besteht im wesentlichen aus einer ebenen Leiterplatte 27 mit elektrisch leitenden Leiterbahnen 29, vier auf ihr fest angeordneten kleinen Blöcken 30 mit Halteleisten 39, einer Führungsplatte 31 und einer Stützplatte 32, sowie sechzehn metallischen Nadeln 33 und als elektrische Verbindungsleitungen von diesen Nadeln 33 zu den zugeordneten metallischen Leiterbahnen 29 dienenden Drähten 34. Die linksseitigen Enden 35 der Leiterbahnen 29 können an eine nicht dargestellte, an der Leiterplatte 27 befestigte Steckerleiste elektrisch angeschlossen sein, die dem Anschluß der Nadelkarte 26 an eine Testeinrichtung einer der Prüfung von Chips auf Wafers dienenden Prüfvorrichtung dient. Auch andere Anschlußmöglichkeiten kommen infrage, bspw. die Anordnung von festen Kontaktpunkten an den Enden der Leiterbahnen, an welche federnde Kontakte, bspw. Federkontaktstifte angedrückt werden können. Es wird dabei jeweils nur ein Chip auf einmal geprüft. Die Nadelkarte 26 ist dabei an einem Nadelkartenhalter eines Prüfadapters oder -kopfes befestigt. Die Nadeln 33 kontaktieren die Pads 14 (Fig. 3) des betreffenden Chips eines Wafers 16. Der Wafer 16 weist eine Vielzahl von nacheinander zu prüfenden Chips auf.

Die Leiterplatte 27 weist einen mittigen quadratischen Durchbruch 36 auf. An ihm ist obenseitig die Stützplatte 32 und untenseitig die Führungsplatte 31 angeordnet, die in Vertiefungen der Leiterplatte unbeweglich eingesetzt und in diesem Ausführungsbeispiel zweckmäßig bündig mit der Oberseite bzw. der Unterseite der Leiterplatte 27 sind.

Die Stützplatte 32 und die zu ihr parallele Führungsplatte 31 haben gleiche Gestalt und sind dünne, aus elektrisch isolierendem Material bestehende Plättchen von bspw. zweckmäßig 0,5 bis 1,5 mm Dicke, vorzugsweise von ungefähr 1 mm Dicke. Sie können jedoch auch noch dünner oder in manchen Fällen auch etwas dicker sein. Zweckmäßig ist ihre Dicke so gering, daß die in ihnen angeordneten Bohrungen für die Nadeln 33 leicht durch Bohren herzustellen sind.

Die zur Führungsplatte 31 parallele Scheibe 37 der Leiterplatte 27 kann dagegen zweckmäßig wesentlich dicker, bspw. zweckmäßig 1 bis 5 mm, und im wesentlichen starr sein. Sie weist eine elektrisch isolierende Kunststoffscheibe 37 auf, auf der die Leiterbahnen 29 angeordnet sind. Diese Kunststoffscheibe 37 ist im wesentlichen starr und hat hier rechteckförmige Gestalt.

Die aus elektrisch isolierenden Materialien bestehenden Führungsplatte 31 und Stützplatte 32 haben ebenfalls je einen mittigen quadratischen Durchbruch. Die Stützplatte 32 und die Führungsplatte 31 bilden so je einen quadratischen Rahmen, in dessen geraden Rahmenseiten in diesem Ausführungsbeispiel je vier zueinander parallele Bohrungen in gerader Reihe angeordnet sind, deren Längsachsen senkrecht zu der Ebene des jeweils zu prüfenden Wafers 16 gerichtet sind. Diese Bohrungen haben zur Gleitlagerung der Nadeln 33 geringfügig größere Durchmesser als die metallischen, federnd elastischen Nadeln 33, die kreisrunde Querschnitte haben und deren freie Enden 59, mit denen sie die Pads 14 des jeweils zu prüfenden Chips senkrecht kontaktieren, spitz zulaufen. Die einzelne Nadel 33 kann zweckmäßig mit Ausnahme ihrer unteren Spitze 59 über ihre Länge konstanten Querschnitt aufweisen. Die Nadeln 33 können zweckmäßig sehr geringe Durchmesser von bspw. 0,05 bis 0,2 mm aufweisen, jedoch ggf. auch noch kleinere oder auch etwas größere Durchmesser, wie es die Mittenabstände der benachbarten, durch sie zu kontaktierenden Pads 14 eines Chips zweckmäßig erscheinen lassen.

Jede Nadel 33 ist in der Führungsplatte 31, der Stützplatte 32 und in einer ihr rückwärtiges Ende unbeweglich haltenden Halteleiste 39 gegen die anderen Nadeln 33 elektrisch isoliert. Sie dürfen sich nicht berühren. Das innerhalb einer Bohrung der Halteleiste 39 endende rückwärtige Ende der einzelnen Nadel 33 ist mittels des an sie elektrisch angeschlossenen, betreffenden metallischen Drahtes 34 an die ihr zugeordnete Leiterbahn 29 der Leiterplatte 27 angelötet.

In diesem Ausführungsbeispiel sind sechzehn Nadeln 33 dargestellt und entsprechend weist die Leiterplatte 27 sechzehn Leiterbahnen 29 auf, so daß jede Nadel 33 an eine nur ihr zugeordnete Leiterbahn 29 elektrisch mittels der betreffenden Verbindungsleitung 34 angeschlossen ist. Die Verbindungsleitung 34 braucht nicht eleastisch zu sein, sie kann zweckmäßg schlapp sein.

Die federnde elastische Nadel 33 kann zweckmäßig aus Kupferberyllium, Edelmetallen, Edelmetallegierungen, Wolfram, Stahl oder sonstigen geeigneten Metallen bestehen.

Es ist auch möglich, vorzusehen, daß die Verbindungleitung 34 mit der federnd elastischen Nadel 33 einstückig verbunden ist, d.h., daß die Nadel 33 zusammen mit der Verbindungsleitung 34 gemeinsam durch einen einzigen metallischen Draht gebildet sind. Es kann dann vorgesehen sein, daß dieser Draht durch unterschiedliche Behandlung im Bereich der Nadel 33 federnd elastisch und im Bereich zwischen der Halteleiste 39 und der betreffenden Leiterbahn 29 schlappe Eigenschaften aufweist. Dieser Draht kann zu diesem Zweck bspw. aus Stahl oder aus Kupferberyllium bestehen, wobei diesem Metall im Bereich der Nadel federelastische Eigenschaften durch Härten bzw. Vergüten und im restliche Bereich durch Nichtbehandlung oder Behandlung, wie Ausglühen oder dgl., schlappe Eigenschaften gegeben sind.

In diesem Ausführungsbeispiel sind nur sechzehn Nadeln 33 an der Nadelkarte 26 angeordnet. In Wirklichkeit ist die Anzahl der Nadeln 33 im allgemeinen viel größer. Bspw. kann diese Nadelkarte 26 ohne weiteres auch mehrere hundert Nadeln aufweisen, bspw. 200 bis 500 Nadeln oder ggf. auch noch mehr oder weniger. Die Mittenabstände (=Nadelteilung) von in einer geraden Nadelreihe parallel nebeneinander angeordneten Nadeln können sehr klein sein. Sie entsprechen den Mittenabständen der Pads einer geraden Reihe von Pads eines Chips, die durch diese Nadeln 33 zu kontaktieren sind. Und zwar sind Chips in Draufsicht normalerweise quadratisch oder rechteckförmig und weisen dann meist entlang allen vier geraden Seiten je eine gerade Reihe von Pads auf. Es gibt auch Chips, bei denen noch zusätzliche Pads einzeln oder in Reihen vorhanden sind, so daß bspw. an einem solchen Chip entlang mindestens einer seiner Längsseiten auch zwei oder mehr Padreihen nebeneinander angeordnet sein können. Die Nadeln der Nadelkarte können dann entsprechend so angeordnet sein, daß ihre Nadelspitzen 59 alle Pads eines Chips gleichzeitig kontaktieren können.

Die erfindungsgemäßen Nadelkarten lassen besonders geringe Mittenabstände zwischen benachbarten Pads 14 zu.

Die Nadeln 33 können in die Halteleisten 39 bspw. eingeklebt sein und an ihre rückwärtigen Enden können dann die Verbindungsdrähte 34 angeschweißt oder angelötet sein oder diese Verbindungsdrähte können einstückig mit den Nadeln 33 sein, wie bereits beschrieben wurde.

Damit diese Nadeln 33 bei axialer Belastung ihrer Spitzen 59 durch Pads 14 elastisch federn können, sind sie, wie dargestellt, zwischen den entsprechend schräg zur Horizontalen gestellten Halteleisten 39 und der horizontalen Stützplatte 32 wie dargestellt in Art eines Parabelastes schwach gebogen.

Die beiden Löcher in der Führungsplatte 31 und der Stützplatte 32, die jeweils eine Nadel 33 stützen und führen, fluchten in diesem Ausführungsbeispiel miteinander, so daß der in der Stützplatte 32 und der Führungsplatte 31 geführte Nadelbereich gerade ist und auch der über die Führungsplatte nach unten um einen geringen Betrag von bspw. zweckmäßig ca. o,2 bis 1 mm überstehende freie Nadelendbereich ist bis zur Spitze 59 ebenfalls gerade und fluchtet mit den ihn führenden Bohrungen der Führungsplatte 31 und der Stützplatte 32.

Die vier Nadeln 33 einer geraden Nadelreihe von parallel nebeneinander angeordneten Nadeln 33 sind jeweils in einer gemeinsamen, aus elektrisch isolierendem Material, wie Kunststoff oder dgl. bestehenden Halteleiste 39 fest gehalten, so daß insgesamt vier solche Halteleisten 39 an den Blöcken 30 schräg geneigt fest angeordnet sind. Benachbarte Halteleisten 39 sind rechtwinklig zueinander angeordnet. Jede Halteleiste 39 ist in den betreffenden kleinen Block aus elektrisch isoliertem Material, wie Kunststoff oder dgl., eingesetzt. Diese vier Blöcke 30 sind - wie dargestellt - rechtwinklig zueinander zu einem Quadrat angeordnet und auf der Scheibe 37 der Leiterplatte 27 befestigt, bspw. an sie angeschraubt oder angeklebt. Die vier Blöcke 30 und die vier Halteleisten 39 sind hier unter sich gleich ausgebildet.

Jede Nadel 33 ist so angeordnet, daß ihre Spitze 59 die Mitte eines von ihr zu kontaktierenden Pads 14 kontaktieren kann. Die Länge der Nadeln 33 kann bspw. zweckmäßig ca. 5 bis 20 mm betragen.

Die ebene Scheibe 37 der Leiterplatte 27 besteht aus elektrisch isolierendem Material, wie glasfaserverstärktem Epoxidharz oder anderen geeigneten, möglichst starren elektrisch isolierenden Werkstoffen.

Wie erwähnt, kann diese komplette Nadelkarte 26 an einem Nadelkartenhalter des Prüfadapters eines Waferprobers oder dergl. befestigt werden. Bei der Prüfung eines Chips wird der betreffende Wafer 16 so unter die Nadelkarte 26 parallel zur Führungsplatte 31 ausgerichtet bewegt, daß die Spitzen 59 der Nadeln 33 alle Pads 14 des betreffenden Chips kontaktieren, und zwar jede Nadel 33 je ein Pad 14. Dazu wird die Nadelkarte 26 zu dem Chip abgesenkt oder der betreffende Wafer 16 nach oben geführt und die Pads 14 drücken dann die Nadelspitzen 59 etwas nach oben, so daß die geraden Bereiche der Nadeln 33 in den Bohrungen der Stützplatte 32 und der Führungsplatte 31 axial aufwärts gleiten und so ihre die Pads kontaktierenden Spitzen 59 gegen die Federwirkung der oberhalb der Stützplatte 32 befindlichen gebogenen Nadelbereiche auf die Führungsplatte 31 zu bewegt werden. Die von den Nadeln 33 auf die Pads 14 ausgeübten Kontaktkräfte können denen der Nadeln vorbekannter Nadelkarten entsprechen, vorzugsweise in der Größenordnung von mehreren cN liegen oder je nach Erfordernis auch größer sein. Die Nadelspitzen 59 können im unbelasteten Zustand zweckmäßig so geringen Abstand von der Führungsplatte 31 haben, bspw. zweckmäßig ca. 0,2 bis 1 mm, daß sie durch die Pads 14 bei deren Kontaktieren bis fast zur Führungsplatte 31 oder auch bis zum ggf. erfolgenden Anliegen der Pads 14 an der Führungsplatte 31 in deren Bohrungen hineinbewegt werden.

Nach erfolgter Prüfung des betreffenden Chips wird der Wafer 16 wieder von den Nadeln 33 weggeführt oder die Nadelkarte 27 nach oben weggeführt und die Nadeln kehren dann in ihre dargestellten Ruhestellungen zurück. Es werden so alle Chips des betreffenden Wafers aufeinanderfolgend geprüft.

Indem im Abstand oberhalb der Führungsplatte 31 eine gesonderte Stützplatte 32 vorgesehen ist, kann diese Stützplatte 32 die durch die gebogenen Bereiche der Nadeln 33 ausgeübten Seitenkräfte der Nadeln 33 im wesentlichen aufnehmen, so daß die Führungsplatte 31 nicht oder nur unwesentlich mit solchen Seitenkräften belastet ist. Dies ermöglicht es, die Nadeln 33 in der Führungsplatte 31 mit besonders geringem Seitenspiel axial zu führen, wogegen das Seitenspiel der Nadeln 33 in der Stützplatte 32 ohne weiteres größer als in der Führungsplatte 31 sein kann.

Hierdurch wird auch erreicht, daß die den Nadelführungen dienenden Bohrungen der Führungsplatte 31 allenfalls nur geringem Verschleiß unterliegen (der Verschleiß der Bohrungen der Stützplatte 32 stört nicht), so daß diese Nadelkarte 26 hohe Betriebssicherheit hat und lange Standzeiten zuläßt und auch sehr genau die Pads 14 jedes zu prüfenden Chips kontaktieren läßt.

Die durch die mittigen Durchbrüche der Leiterplatte, der Stützplatte und der Führungsplatte geschaffene Durchsichtsmöglichkeit durch diese Nadelkarte 26 hindurch dient der mikroskopischen Beobachtung der Nadelspitzen 59 zwecks Justieren der Nadelkarte oder für songstige Zwecke.

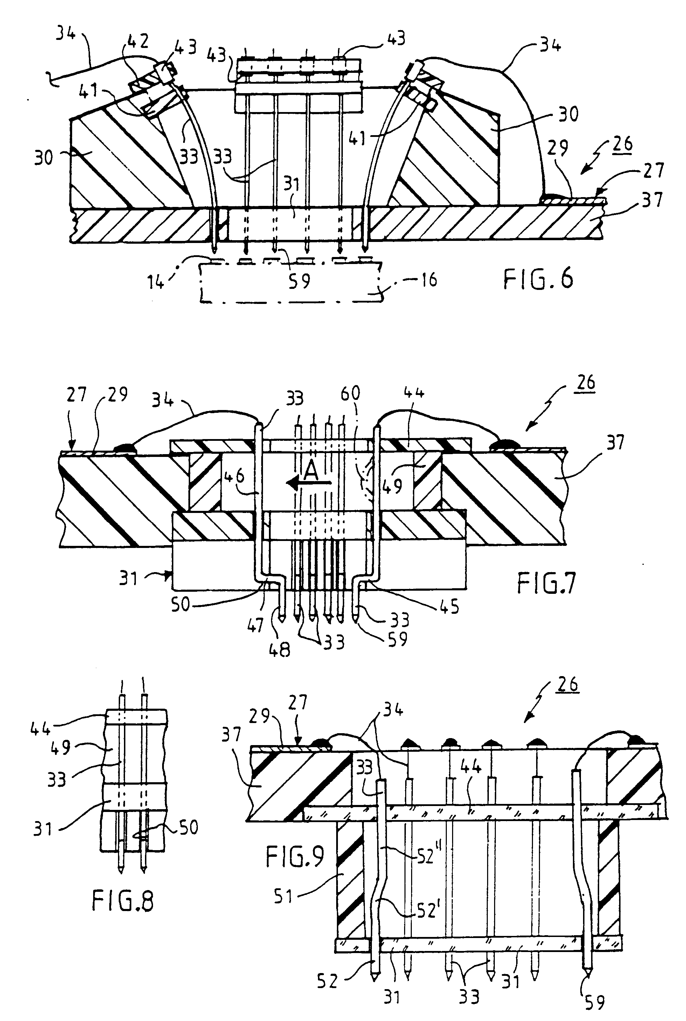

Bei der in Fig. 4 ausschnittsweise dargestellten Nadelkarte 26 sind die Halteleisten 39 in schräg zur Horizontalen gerichteten Stellungen direkt an der Scheibe 37 der Leiterplatte 27 befestigt. Ferner ist hier keine Stützplatte vorhanden, sondern die Nadeln 33 sind nur in zueinander parallelen Bohrungen einer Führungsplatte 31 geführt und von ihr aus direkt zu den sie haltenden Halteleisten 39 geführt. Die über die Halteleisten 39 etwas nach oben überstehenden oberen Nadelenenden sind mittels der an sie angeschweißten oder angelöteten elektrischen Verbindungsdrähten 34 mit den zugeordneten Leiterbahnen 29 der Leiterplatte 27 verbunden, wobei die Verbindungsdrähte 34 an die Leiterbahnen 29 angelötet sind.

In diesem Ausführungsbeispiel nach Fig. 4 ist also keine Stützplatte vorhanden, so daß die zur Scheibe 37 parallele Führungsplatte 31 hier auch die Seitenkräfte der Nadeln 33 aufnehmen muß. Sie ist hierzu möglichst steif auszubilden und weist deshalb keinen mittigen Durchbruch mehr auf, sondern ist zwecks Durchsicht durch sie als glasklare Scheibe ausgebildet, die elektrisch isoliert. Sie kann bevorzugt aus Glas, Silizium oder Kunststoff bestehen. Infolge ihrer glasklaren Ausbildung ist sie also durchsichtig, so daß auch bei dieser Nadelkarte die unteren freien Enden 59 der Nadeln von oben her zwecks genauer Justierung der Nadelkarte 26 oder dgl. mikroskopisch beobachtet werden können. Auch bei dieser Nadelkarte 26 können vier Halteleisten 39 in rechteckförmiger oder quadratischer Anordnung vorgesehen sein, von denen nur drei zu sehen sind.

Falls bei sehr geringen Seitenabständen der Nadeln 33 die Gefahr bestehen könnte, daß sie infolge ihres Biegens beim Kontaktieren von Prüflingen sich seitlich kontaktieren könnten, kann in diesem Fall und auch bei sonstigen erfindungsgemäßen Nadelkarten vorgesehen sein, daß sie auf den betreffenden Bereichen oder auch darüber hinaus mit elektrisch isolierenden Überzügen, Umhüllungen oder dergl. versehen sind, bspw. mit Isolierlack überzogen sind. In Fig. 4 kann dies zweckmäßig der Bereich der Nadeln 33 zwischen den Halteleisten 39 und der Führungsplatte 31 und in Fig. 5 zwischen den Halteleisten 39 und der Stützplatte 32 sein.
Die in Fig. 5 ausschnittsweise dargestellte Nadelkarte 26 entspricht der nach Fig. 4 mit dem Unterschied, daß hier an der Unterseite der Leiterplatte 27 eine zur Scheibe 37 parallele Stützplatte 32 fest angeordnet ist, die über einen Zwischenring 40 mit der zur Scheibe 37 parallelen Führungsplatte 31 fest verbunden ist. In der Stützplatte 32 sind für die Nadeln 33 zueinander parallele Bohrungen vorgesehen, von denen jede mit der für die betreffende Nadel 33 bestimmten Bohrung in der Führungsplatte 31 exakt fluchtet. In diesen Bohrungen können die Nadeln 33 axial gleiten. Die Führungs- und die Stützplatte 31,32 haben keine mittigen Durchbrüche und sind hierdurch wieder mechanisch fester als wenn sie Durchbrüche hätten. Zwecks mikroskopischer Beobachtung der Nadelspitzen 59 können deshalb die Stützplatten 32 als auch die Führungsplatte 31 aus durchsichtigem, glasklarem Material, wie Glas, Kunststoff, Silizium oder dgl. hergestellt sein. Der Zwischenring 40 kann auch durchsichtig sein, jedoch auch aus undurchsichtigem Werkstoff bestehen. Die Stützplatte 32 nimmt bei dieser Ausführungsform im wesentlichen die Nadelseitenkräfte auf. Die Führungsplatte 31 dient der exakten Führung der Nadeln 33 nahe deren Spitzen 59, mit denen sie die Pads von zu prüfenden Chips auf Wafers kontaktieren.

Bei der eine Abwandlung der Fig. 3 ausschnittsweise zeigenden Nadelkarte 26 nach Fig. 6 dient die die Leiterbahnen 29 aufweisende, im wesentlichen starre Scheibe 37 der Leiterplatte 27 gleichzeitig als Führungsplatte 31 für die Nadeln 33. Infolge der relativ großen Dicke der Scheibe 37, die im allgemeinen einige Millimeter beträgt, müssen die sehr dünnen, zueinander parallelen Löcher für die Nadeln 33 in dieser Scheibe 37 entsprechend lang sein. Diese Löcher sind deshalb um so schwieriger zu bohren, je kleiner ihr Durchmesser ist. Deshalb ist diese Nadelkarte 26 bevorzugt für relativ dicke Nadeln 33 geeignet.

Auf der Scheibe 37 sind wiederum vier Blöcke 30 wie bei Fig. 3 befestigt, die hier jedoch keine Halteleisten tragen, an denen die hinteren Nadelenden fest angeordnet sind. Vielmehr sind an jedem Block 30 je zwei zueinander parallele Leisten 41,42 schräg zur Ebene der Führungsplatte 31 übereinander fest angeordnet. Die Leiste 41 weist von den betreffenden Nadeln 33 mit Gleitlagerspiel durchdrungene Bohrungen auf, die zusammen mit den von den Nadeln 33 durchdrungenen Bohrungen der Führungsplatte 31 die Nadeln 33 wiederum im Bereich zwischen ihnen und der Führungsplatte 31 zwecks axialer Federung der Nadelspitzen 59, wie dargestellt, parabelartig gebogen halten. Die Nadeln 33 sind in entspanntem Zustand schwächer als dargestellt gebogen, so daß sie sich infolge der durch die Führungsplatte 31 und die Leisten 41 erzwungenen, dargestellten Biegungen durch die hierdurch erzeugte Reibung in den Bohrungen dieser Scheibe 37 und Leiste 41 von selbst halten. Die oberen, d.h. rückwärtigen Nadelenden liegen an metallischen Kontaktstücken 43 an, die Widerlager für die Nadeln 33 bilden. Jede Nadel 33 liegt an einem nur ihr zugeordneten Kontaktstück 43 an, das mit der zugeordneten Leiterbahn 29 der Leiterplatte 27 mittels eines Verbindungsdrahtes 34 elektrisch verbunden ist. Diese Ausführungsform hat den großen Vorteil, daß die Nadeln 33, wenn sie beschädigt sind, einzeln leicht und rasch ausgewechselt werden können. Hierzu ist es nur erforderlich, sie aus den Bohrungen der Führungsplatte 31 und der betreffenden Leiste 41 herauszuziehen und in diese beiden Bohrungen eine neue Nadel 33 einzuführen, die dann wieder bis zum Anliegen ihres oberen Endes an den betreffenden Kontakt 43 nach oben geschoben wird. Diese Nadeln 33 halten sich also durch Reibung von selbst in der Führungsplatte 37 und der Leiste 41. Wenn die Nadeln 33 durch die Pads 14 von zu prüfenden Wafers 16 mit ihren unteren Nadelspitzen 59 gegen die eigene Federwirkung unter Gleiten in den Bohrungen der Scheibe 37 gegen die von ihnen selbst ausgeübte Federkraft nach oben gedrückt werden, dann erhöht sich die Anpreßkraft der rückwärtigen Enden der Nadeln 33 an die Kontakte 43 entsprechend und es ist so während der Prüfung jedes Chips guter elektrischer Kontakt zwischen den Nadeln 33 und den zugeordneten Kontakten 43 sichergestellt.

Bei der Ausführungsform nach Fig. 7 und 8 sind die Nadeln 33 fest in Bohrungen einer an der Oberseite der ebenen Scheibe 37 der Leiterplatte 27 parallel zu ihr befestigten ebenen Halteplatte 44 gehalten. An ihre oberen Enden sind zu den Leiterbahnen 29 der Leiterplatte 27 führende elektrische Verbindungsdrähte 34 angelötet. Jede Nadel 33 weist eine Abkröpfung 45 auf. Sie weist so einen langen geraden Bereich 46 auf, der über einen kurzen, rechtwinklig zu ihr verlaufenden Bereich 47 zu einem wiederum parallel zum langen Bereich verlaufenden kurzen freien Endbereich 48 führt. Die langen Nadelbereiche 46 durchdringen zueinander parallele Bohrungen in einer Führungsplatte 31 mit geringem Gleitlagerspiel. Diese Führungsplatte 31 ist mittels eines Distanzringes 49 an der zu ihr parallelen Halteplatte 44 im Abstand unterhalb von ihr befestigt.

Diese Führungsplatte 31 weist für die geraden, zueinander parallelen Bereiche 46 der Nadeln 33 Bohrungen zu deren Führungen auf. Unterhalb jeder dieser Bohrungen befindet sich in der Führungsplatte 31 ein schmaler Schlitz 50, in den der abgekröpfte Bereich 45 der betreffenden Nadel 33 - wie dargestellt teilweise hineinragt, wodurch der abgekröpfte Bereich 45 der Nadel 33 sich nicht drehen kann. Für jede Nadel 33 ist ein solcher Schlitz 50 vorgesehen und bildet so eine Drehsicherung für die Nadel 33.

Ferner weisen sowohl die Halteplatte 44 wie auch die Führungsplatte 31 einen mittigen Durchbruch innerhalb der Nadelanordnung auf zur mikroskopischen Beobachtung der freien Nadelspitzen 59.

Die freien Nadelspitzen 59 können infolge der Abkröpfungen 45 der metallischen Nadeln 33 aufwärts federn, wenn sie auf Pads von zu prüfenden Chips auftreffen und durch diese nach oben gedrückt werden. Dabei können sich auch die langen Bereiche 46 der Nadeln 33 infolge der über die Abkröpfungen 45 übertragenen Kräfte etwas biegen und die Nadeln 33 auch in den Bohrungen der Führungsplatte 31 etwas gleiten. Ggf. können die zwischen der Führungsplatte 31 und der Halteplatte 44 befindlichen Nadelbereiche für leichtere Federung auch etwas vorgebogen sein, wie es als Beispiel bei 60 für eine der Nadeln 33 strichpunktiert eingezeichnet ist.

Die in Fig. 9 geschnitten ausschnittsweise dargestellte Nadelkarte 26 weist eine gegen die Unterseite der Scheibe 37 ihrer Leiterplatte 27 eingelassene dünne Halteplatte 44 auf, in der die Nadeln 33 nahe ihren rückwärtigen oberen Enden Bohrungen dieser Halteplatte 44 durchdringend fest angeordnet sind. Bspw. können die Nadeln 33 in die Bohrungen der Halteplatte 44 eingeklebt sein. Die oberen Enden dieser Nadeln 33 sind über Verbindungsdrähte 34 an die zugeordneten Leiterbahnen 29 der Leiterplatte 27 angeschlossen. An der Unterseite der Halteplatte 44 ist ein die Nadeln 33 im Abstand umfassender Distanzring 51 fest angeordnet, an dem untenseitig die dünne Führungsplatte 31 befestigt ist, die sich wie auch die Halteplatte 44 parallel zur Scheibe 37 und damit parallel zur Ebene von durch die Nadelspitzen 59 kontaktierten Wafers erstreckt. Die Nadeln 33 durchdringen mit Gleitlagerspiel zueinander parallele Bohrungen der Führungsplatte 31 und sind im Bereich zwischen dieser Führungsplatte 31 und der Halteplatte 44 bei 52′ wie dargestellt schwach S-förmig so gebogen, so daß ein unterer, in der Bohrung der Führungsplatte gerader Endbereich 52 der einzelnen Nadel 33 zu dem in der Halteplatte 44 behaltenen geraden oberen Bereich 52˝ der Nadel 33 etwas achsparallel versetzt ist. Hierdurch können die Nadelspitzen 59, wenn sie durch Pads von zu kontaktierenden Chips axial nach oben gedrückt werden, durch federndes Biegen der Nadeln 33 axial federn, wobei die unteren geraden Nadelbereiche 52 entsprechend axial in den Bohrungen der Führungsplatte 31 gleiten.

Die Halteplatte 44 und die Führungsplatte 31 haben in diesem Ausführungsbeispiel wegen möglichst großer Steifigkeit keine Durchbrüche innerhalb der Nadelanordnung, sondern bestehen aus glasklaren, elektrisch isolierenden Materialien, wie Glas, Silizium, Kunststoff oder dgl. zwecks mikroskopischer Beobachtung der Nadelspitzen 59.

Das Ausführungsbeispiel der Nadelkarte 26 nach Fig. 10 weist eine in einen mittigen Durchbruch der Scheibe 37 einer Leiterplatte 27 fest eingesetzte plane Scheibe oder Block 53 aus glasklarem Material wie Glas oder dgl. auf, in dem für jede gerade Nadelreihe ein horizontaler Durchgangskanal 61 angeordnet ist, der von den betreffenden Nadeln 33 durchdrungen ist. Für rechteckförmige Chips mit je einer Padreihe entlang jeder Seite sind dann also vier Durchgangskanäle 61 rechtwinklig zueinander angeordnet.

Die gemeinsame Decke dieser Kunststoffkanäle bildet eine Halteplatte 44 für die Nadeln 33 und der gemeinsame Boden dieser vier Kanäle bildet eine Führungsplatte 31. Die Halteplatte 44 und die Führungsplatte 31 sind also Bestandteile derselben einstückigen Scheibe 53. Der untere Endbereich 55 jeder Nadel ist gerade und in einer Bohrung der Führungsplatte 31 axial gleitbar mit geringem Gleitlagerspiel geführt. An diesen Bereich 55 schließt ein kreisbogenförmig gekrümmter Bereich 56 der Nadel 33 und an diesen ein gerader oberer Endbereich 57 der Nadel an, dessen oberes Ende mittels eines Verbindungsdrahtes 34 mit der zugeordneten Leiterbahn 29 der Leiterplatte 27 elektrisch leitend verbunden ist. Dieser gerade obere Nadelendbereich 57 durchdringt eine Bohrung der Halteplatte 44 und ist in dieser Bohrung fest angeordnet, bspw. eingeklebt. Dieser gerade obere Nadelbereich 57 fluchtet mit dem unteren geraden Bereich 55 der Nadel 33. Indem die Scheibe 53 durchsichtig ist, ist eine mikroskopische Beobachtung der freien unteren Nadelspitzen 5 9, die dem Kontaktieren der Pads von Chips dienen, möglich.

In allen Ausführungsbeispielen sind die der axialen Führung der Nadeln 33 dienenden Bohrungen der Führungsplatten 31 so angeordnet, daß ihre Längsachsen parallel zueinander und senkrecht zu der Ebene eines Wafers 16 gerichtet sind, den die Nadelspitzen 59 jeweils kontaktieren. Dies ist besonders vorteilhaft und macht auch die Herstellung der Bohrungen der Führungsplatte 31 leichter. In manchen Fällen kann jedoch auch vorgesehen sein, daß diese Bohrungen der Führungsplatte 31 so angeordnet sind, daß sie nicht zueinander achsparallel sind oder nur Gruppen von ihnen zueinander achsparallel angeordnet sind. Bspw. können die einer geraden Nadelreihe dienenden Bohrungen der Führungsplatte schräg zur Ebene der Führungsplatte und der Ebene des jeweils zu prüfenden Wafers geneigt sein, vorzugsweise nur wenig geneigt sein, bspw. unter Winkeln von ca. 1° bis 25° geneigt sein, ggf. aber auch noch weniger oder auch mehr. Beim Hochbewegen der Nadelspitzen durch die von diesen kontaktierten Pads eines zu prüfenden Chips kann es dann zum geringen Gleiten der Nadelspitzen auf den Pads kommen, was zwar den elektrischen Kontakt verbessern kann, jedoch die Pads dann zur Vermeidung oder Verringerung der hierdurch bedingten Beschädigungsgefahr robuster sein müssen, als wenn sie nur punktförmig kontaktiert werden.

Ferner kann in manchen Fällen auch vorgesehen sein, daß anstelle einer einzigen Führungsplatte 31 mehrere Führungsplatten vorgesehen sind. Bspw. könnte im Ausführungsbeispiel nach den Fig. 2 und 3 der durch die Führungsplatte 31 gebildete Rahmen aus mehreren Führungsplatten zusammengesetzt sein, vorzugsweise je Rahmenseite eine gesonderte Führungsplatte vorgesehen sein, d.h. je gerade Nadelreihe. Entsprechendes gilt auch für die Stützplatte 32, so daß ggf. anstelle einer einzigen Stützplatte 32 auch mehrere Stützplatten 32 vorgesehen sein können.

In allen Ausführungsbeispielen kann zweckmäßig vorgesehen sein, daß der Überstand der Nadeln nach unter über die Führungsplatte 31 so gering wie möglich ist, vorzugsweise nur so groß ist, daß die für das Kontaktieren der Pads 14 der Chips vorgesehenen Kontaktkräfte, die die Nadelspitzen 59 auf die Pads 14 zum sicheren elektrischen Kontakt ausüben sollen, erreicht werden, wenn die Pads 14 an der Führungsplatte 31 zur Anlage oder fast zur Anlage kommen.

In allen Ausführungsbeispielen sind ferner die Führungsplatten 31 wie auch die Stützplatten 32 und die Scheiben 37 der Leiterplatten 27 parallel zu den Ebenen der durch die Nadelspitzen 59 der Nadeln 33 jeweils kontaktierten Pads 14 und damit parallel zu den diese Pads 14 aufweisenden Wafers bei deren Prüfungen gerichtet, was besonders zweckmäßig ist.

## Patentansprüche

1. Nadelkarte (26) für Prüfeinrichtungen, die der Prüfung von Chips aufweisenden Wafer auf elektrische Fehlerfreiheit der Chips dienen, welche Nadelkarte (26) eine Nadelanordnung aufweist, die von einer Leiterplatte (27) getragen wird, die elektrische Leiterbahnen (29) aufweist, an die metallische elektrische Leitfähigkeit aufweisende, beim Kontaktieren der Wafer elastisch federnde Nadeln (33) der Nadelanordnung elektrisch angeschlossen sind, wobei die Nadeln (33) der Nadelanordnung dem gleichzeitigen Kontaktieren von an einem jeweils zu prüfenden Chip angeordneten Pads dienen, **dadurch gekennzeichnet,** daß die Nadeln (33) mittels mit diesen verbundenen Verlängerungen (34) direkt mit den Leiterbahnen (29) verbunden sind, daß die bei axialer Belastung aufgrund mindestens einer Krümmung elastisch federnden Nadeln (33) in der Gleitlagerung dienenden Löchern mindestens einer, im Bereich eines Durchbruchs der Leiterplatte (27) gelegenen und von der Leiterplatte (27) getragenen Führungsplatte (31) axial gerade geführt sind, benachbart der sich die dem Kontaktieren der Pads (14) dienenden Spitzen (59) der Nadeln (33) befinden.

2. Nadelkarte nach Anspruch 1, **dadurch gekennzeichnet,** daß die Längsachsen der der Nadelführung dienenden Löcher der Führungsplatte (31) zueinander parallel sind.

3. Nadelkarte nach Anspruch 1 oder 2, **dadurch gekennzeichnet,** daß eine einzige Führungsplatte (31) vorgesehen ist.

4. Nadelkarte nach einem der vorhergehenden Ansprüche, **dadurch gekennzeichnet**, daß der von den Nadeln (33) durchdrungene Durchbruch (36) die Leiterplatte (27) mittig durchsetzt.

5. Nadelkarte nach einem der vorhergehenden Ansprüche, **dadurch gekennzeichnet**, daß die Führungsplatte (31) an der Unterseite der Leiterplatte (27) angeordnet ist.

6. Nadelkarte nach einem der vorhergehenden Ansprüche, **dadurch gekennzeichnet**, daß im Abstand von der Führungsplatte (31) mindestens eine Stützplatte (32) angeordnet ist, die Löcher aufweist, die ebenfalls von den Nadeln mit Gleitlagerspiel durchdrungen sind, wobei vorzugsweise die Löcher der Stützplatte (32) mit den zugeordneten Löchern der Führungsplatte (31) fluchten.

7. Nadelkarte nach Anspruch 1, **dadurch gekennzeichnet**, daß jede Nadel (33) einen geraden Bereich aufweist, der sich von ihrer dem Kontaktieren von Pads (14) dienenden Spitze (59) aus durch die Führungsplatte (31) und vorzugsweise auch durch die Stützplatte (32) hindurch erstreckt.

8. Nadelkarte nach einem der Ansprüche 6 oder 7, **dadurch gekennzeichnet**, daß die Stützplatte (32) an der Ober- oder Unterseite der Leiterplatte (27) angeordnet ist.

9. Nadelkarte nach einem der vorhergehenden Ansprüche, **dadurch gekennzeichnet**, daß die rückwärtigen Endbereiche der Nadeln (33) in Bohrungen mindestens eines Halteelements (39;44) unbeweglich gehalten sind.

10. Nadelkarte nach einem der Ansprüche 1, 8 oder 9, **dadurch gekennzeichnet**, daß jede Nadel (33) im Bereich zwischen ihrer dem Kontaktieren von Pads (14) dienenden Spitze (59) und der Führungsplatte (31) mindestens die eine Krümmung, vorzugsweise eine Abkröpfung (45), aufweist, vorzugsweise der abgekröpfte Bereich in einem Schlitz (50) der Führungsplatte (31) gegen Drehen gesichert ist.

11. Nadelkarte nach einem der vorhergehenden Ansprüche, **dadurch gekennzeichnet**, daß der rückwärtige Endbereich der einzelnen Nadel (33) in einer Bohrung gehalten oder axial beweglich geführt ist, deren Längsachse zu der Längsachse von der betreffenden Nadel durchdrungenen Bohrung der Führungsplatte und/oder der Stützplatte (32) schräg geneigt ist.

12. Nadelkarte nach einem der vorhergehenden Ansprüche, **dadurch gekennzeichnet**, daß die Führungsplatte (31) und gegebenenfalls auch die Stützplatte (32) aus glasklar durchsichtigem Material besteht beziehungsweise bestehen, vorzugsweise aus Kunststoff, Glas oder Silizium.

13. Nadelkarte nach Anspruch 12, **dadurch gekenn****zeichnet**, daß die Führungsplatte (31) durch einen einstückigen, durchsichtigen Glaskörper gebildet ist, der im Abstand von den Bohrungen der Führungsplatte noch eine Halteplatte (44) oder Stützplatte für die Nadeln (33) bildet, welche Halte- oder Stützplatte Bohrungen für die Nadeln aufweist.

14. Nadelkarte nach einem der vorhergehenden Ansprüche, **dadurch gekennzeichnet,** daß die Nadelkarte mindestens den einen Durchbruch aufweist, vorzugsweise innerhalb der Nadelanordnung, durch den hindurch eine mikroskopische Beobachtung der freien Nadelspitzen (59), einer dem Inken dienender Düse oder dergleichen möglich ist.

15. Nadelkarte nach einem der Ansprüche 1 bis 8 oder 10 bis 14, **dadurch gekennzeichnet,** daß die Nadeln (33) an der Nadelkarte (26) lösbar gehalten sind.

16. Nadelkarte nach Anspruch 15, **dadurch gekennzeichnet**, daß die einzelne Nadel nur durch Reibung gehalten ist.

17. Nadelkarte nach Anspruch 16, **dadurch gekennzeichnet**, daß die einzelne Nadel (33) in dem sie gleitbar lagernden Loch der Führungsplatte (31) und in mindestens einem im Abstand von der Führungsplatte angeordneten anderen Loch durch Reibung gehalten ist und ihr rückwärtiges Ende an einem ein Widerlager für sie bildenden elektrischen Kontakt (43) anliegt, der mit dem ihr jeweils zugeordneten Leiter (29) der Leiterplatte elektrisch verbunden ist.

18. Nadelkarte nach einem der vorhergehenden Ansprüche, **dadurch gekennzeichnet**, daß der Abstand der freien Nadelspitzen (59) von der oder den Führungsplatten (31) so klein wie möglich ist.

19. Nadelkarte nach einem der vorhergehenden Ansprüche, **dadurch gekennzeichnet**, daß die Nadeln auf mindestens einem Längsbereich mit einem elektrisch isolierenden Überzug, Umhüllung oder dergleichen versehen sind.

## Claims

1. A needle card (26) for testing devices for testing the electrical integrity of chips on wafers, the said needle card (26) having a needle arrangement carried by a printed circuit board (27) having electric conducting tracks (29), to which metallic, electrically conductive needles (33) of the needle arrangement are electrically connected, the said needles (33) yielding resiliently on contacting the wafers, wherein the needles (33) of the needle arrangement are used for simultaneously contacting pads arranged on a respective chip to be tested, characterised in that the needles (33) are directly connected to the conducting tracks (29) by means of extensions (34) connected to the said needles (33), and in that the needles (33), which yield resiliently under axial load owing to at least one bend, are axially aligned in holes serving as a sliding mounting and provided in at least one guide plate (31) arranged in the region of an opening in the printed circuit board (27) and carried by the printed circuit board (27), the points (59) of the needles (33) being located adjacent to the said guide plate (31) and serving to contact the pads (14).

2. A needle card according to claim 1, characterised in that the longitudinal axes of the holes in the guide plate (31) are parallel to each other, the said holes serving to guide the needles.

3. A needle card according to claim 1 or 2, characterised in that a single guide plate (31) is provided.

4. A needle card according to any one of the preceding claims, characterised in that the opening (36), penetrated by the needles (33), extends through the printed circuit board (27) centrally.

5. A needle card according to any one of the preceding claims, characterised in that the guide plate (31) is arranged on the underside of the printed circuit board (27).

6. A needle card according to any one of the preceding claims, characterised in that at least one supporting plate (32) is arranged at a distance from the guide plate (31) and has holes which are also penetrated by the needles with slide bearing play, the holes in the supporting plate (32) preferably being aligned with the associated holes in the guide plate (31).

7. A needle card according to claim 1, characterised in that each needle (33) has a straight region which, starting from the point (59) for contacting pads (14), extends through the guide plate (31) and preferably also through the supporting plate (32).

8. A needle card according to either one of claims 6 and 7, characterised in that the supporting plate (32) is arranged on the upper side or underside of the printed circuit board (27).

9. A needle card according to any one of the preceding claims, characterised in that the rear end regions of the needles (33) are immovably held in bores of at least one holding element (39; 44).

10. A needle card according to any one of claims 1, 8 and 9, characterised in that each needle (33) has at least one bend, preferably an offset (45), in the region between its point (59), for contacting pads (14), and the guide plate (31), and the offset region is preferably secured against rotation in a slot (50) of the guide plate (31).

11. A needle card according to any one of the preceding claims, characterised in that the rear end region of each individual needle (33) is held or axially movably guided in a bore, the longitudinal axis of which is inclined at an angle to the longitudinal axis of the bore of the guide plate and/or the supporting plate (32), the said bore being penetrated by the relevant needle.

12. A needle card according to any one of the preceding claims, characterised in that the guide plate (31) and, if necessary, also the supporting plate (32) comprises or comprise transparent material, preferably plastics, glass or silicon.

13. A needle card according to claim 12, characterised in that the guide plate (31) is formed by a one-piece, transparent glass body which, at a distance from the bores of the guide plate, forms a further holding plate (44) or supporting plate for the needles (33), the said holding or supporting plate having bores for the needles.

14. A needle card according to any one of the preceding claims, characterised in that the needle card has at least one opening, preferably within the needle arrangement, through which microscopic observation of the free needle points (59) or a nozzle provided for inking purposes or the like is possible.

15. A needle card according to any one of claims 1 to 8 or 10 to 14, characterised in that the needles (33) are detachably held on the needle card (26).

16. A needle card according to claim 15, characterised in that each individual needle is only held by friction.

17. A needle card according to claim 16, characterised in that each individual needle (33) is slidingly mounted and held by friction in the hole in the guide plate (31) and in at least one other hole arranged at a distance from the guide plate, and its rear end rests against an electrical contact (43) forming an abutment for the said needle and being electrically connected to the conductor (29) - associated therewith - of the printed circuit board.

18. A needle card according to any one of the preceding claims, characterised in that the distance between the free needle points (59) and the guide plate or plates (31) is as small as possible.

19. A needle card according to any one of the preceding claims, characterised in that the needles on at least one longitudinal region are provided with an electrically insulating coating, covering or the like.

## Revendications

1. Carte à aiguilles (26) pour des dispositifs d'essai qui servent à essayer des pastilles comportant des puces de circuits intégrés en ce qui concerne l'absence de défauts électriques de ces puces, carte à aiguilles (26) qui comprend un arrangement d'aiguilles porté par un circuit imprimé (27) comportant des pistes conductrices de l'électricité (29) auxquelles sont reliées électriquement des aiguilles (33) de l'arrangement d'aiguilles qui présentent la conductibilité électrique des métaux et qui font ressort élastiquement lors du contact avec la pastille, les aiguilles (33) de l'arrangement d'aiguilles servant à établir un contact simultané avec des plots de connexion disposés sur chaque puce à essayer, caractérisée par le fait que les aiguilles (33), au moyen de prolongements (34) reliés à celles-ci, sont reliées directement aux pistes conductrices (29), et par le fait que les aiguilles (33), lesquelles font ressort élastiquement lors d'une charge axiale, du fait d'au moins une courbure, sont guidées en coulissement axial dans des trous formant paliers de glissement d'au moins une plaque de guidage (31) qui est située dans la région d'une ouverture du circuit imprimé (27), qui est portée par le circuit imprimé (27) et au voisinage de laquelle se trouvent les pointes (59) des aiguilles (33) qui servent à venir en contact avec les plots de connexion (14).

2. Carte à aiguilles selon la revendication 1, caractérisée par le fait que les axes longitudinaux des trous de la plaque de guidage (31) qui servent à guider les aiguilles sont parallèles entre eux.

3. Carte à aiguilles selon la revendication 1 ou 2, caractérisée par le fait qu'il est prévu une seule plaque de guidage (31).

4. Carte à aiguilles selon l'une des revendications précédentes, caractérisée par le fait que l'ouverture (36) traversée par les aiguilles (33) traverse le circuit imprimé (27) en son centre.

5. Carte à aiguilles selon l'une des revendications précédentes, caractérisée par le fait que la plaque de guidage (31) est disposée sur le côté inférieur du circuit imprimé (27).

6. Carte à aiguilles selon l'une des revendications précédentes, caractérisée par le fait qu'au moins une plaque d'appui (32) est disposée à distance de la plaque de guidage (31), et qu'elle présente des trous qui sont également traversés par les aiguilles avec un jeu de palier de glissement, les trous de la plaque d'appui (32) étant de préférence alignés sur les trous correspondants de la plaque de guidage (31).

7. Carte à aiguilles selon la revendication 1, caractérisée par le fait que l'aiguille (33) présente une partie droite qui, à partir de sa pointe (59) servant au contact avec des plots de connexion (14), s'étend à travers la plaque de guidage (31) et également, de préférence, à travers la plaque d'appui (32).

8. Carte à aiguilles selon l'une des revendications 6 et 7, caractérisée par le fait que la plaque d'appui (32) est disposée sur le côté supérieur ou sur le côté inférieur du circuit imprimé (27).

9. Carte à aiguilles selon l'une des revendications précédentes, caractérisée par le fait que les extrémités arrière des aiguilles (33) sont maintenues fixes dans des perçages d'au moins un élément de maintien (39 ; 44).

10. Carte à aiguilles selon l'une des revendications 1, 8 et 9, caractérisée par le fait que chaque aiguille (33), dans sa partie située entre la pointe (59) servant au contact avec des plots de connexion (14) et la plaque de guidage (31), présente au moins une courbure qui est de préférence un coude (45), la partie coudée étant de préférence empêchée de tourner du fait qu'elle passe dans une fente (50) de la plaque de guidage (31).

11. Carte à aiguilles selon l'une des revendications précédentes, caractérisée par le fait que l'extrémité arrière des diverses aiguilles (33) est maintenue, ou guidée en pouvant se déplacer axialement, dans un perçage dont l'axe longitudinal est incliné en oblique par rapport à l'axe longitudinal du perçage de la plaque de guidage et/ou de la plaque d'appui (32) qui est traversé par l'aiguille concernée.

12. Carte à aiguilles selon l'une des revendications précédentes, caractérisée par le fait que la plaque de guidage (31) et la plaque d'appui (32) également, le cas échéant, est constituée ou, respectivement, sont constituées par une matière claire et transparente et, de préférence, par de la matière plastique, du verre ou du silicium.

13. Carte à aiguilles selon la revendication 12, caractérisée par le fait que la plaque de guidage (31) est constituée par un corps en verre transparent en une seule pièce qui constitue aussi une plaque de maintien (44) ou une plaque d'appui pour les aiguilles (33) à distance des perçages de la plaque de guidage, cette plaque de maintien ou d'appui présentant des perçages destinés aux aiguilles.

14. Carte à aiguilles selon l'une des revendications précédentes, caractérisée par le fait que la carte à aiguilles présente au moins une ouverture, de préférence à l'intérieur de l'arrangement d'aiguilles, à travers laquelle il est possible d'observer au microscope la pointe libre (59) des aiguilles, ou une embouchure d'encrage ou similaire.

15. Carte à aiguilles selon l'une des revendications 1 à 8 et 10 à 14, caractérisée par le fait que les aiguilles (33) sont maintenues de manière amovible sur la carte à aiguilles (26).

16. Carte à aiguilles selon la revendication 15, caractérisée par le fait que les diverses aiguilles ne sont maintenues que par frottement.

17. Carte à aiguilles selon la revendication 16, caractérisée par le fait que les diverses aiguilles (33) sont maintenue par frottement dans le trou de la plaque de guidage (31) dans lequel elles peuvent coulisser et dans au moins un autre trou disposé à distance de la plaque de guidage, son extrémité arrière portant sur un contact électrique (43) qui constitue pour elles une butée et qui est relié électriquement au conducteur correspondant (29) du circuit imprimé.

18. Carte à aiguilles selon l'une des revendications précédentes, caractérisée par le fait que la distance entre les pointes libres (59) des aiguilles et la ou les plaques de guidage (31) est aussi faible que possible.

19. Carte à aiguilles selon l'une des revendications précédentes, caractérisée par le fait que les aiguilles sont munies, sur une partie longitudinale au moins, d'un revêtement, d'une gaîne ou similaire qui est électriquement isolant.
